# EUROPEAN PATENT APPLICATION

(11) **EP 4 658 024 A1**
(43) Date of publication of application: **03.12.2025**
(21) Application number: 25756429.4
(22) Date of filing: 25.02.2025
(51) Int. Cl.: H10F 10/00, H10F 19/90, H10F 77/42

(54) **DOUBLE-SIDED REFLECTIVE GAP FILM AND BIFACIAL PHOTOVOLTAIC MODULE**

(30) Priority: 26.02.2024 CN 202420351969 U
(71) Applicant: Trina Solar Co., Ltd, Changzhou, Jiangsu 213031 (CN)
(72) Inventor: JIANG, Zhongwei, Changzhou, Jiangsu 213031 (CN); SHUAI, Lifang, Changzhou, Jiangsu 213031 (CN); ZHANG, Zijian, Changzhou, Jiangsu 213031 (CN); WANG, Le, Changzhou, Jiangsu 213031 (CN)
(74) Representative: Canzler & Bergmeier Patentanwälte Partnerschaft mbB
(86) International application number: PCT/CN2025/079015
(87) International publication number: WO 2025/180361

(57) **Abstract**

The present disclosure provides a bifacial reflective gap film, including: a back bonding layer, an intermediate support layer, a front reflective structure, and a back reflective structure. The front reflective structure is disposed on one side of the intermediate support layer and includes a plurality of inverted V-shaped toothed members arranged side by side, and the front reflective structure is coated with a front reflective layer, the back reflective structure is disposed on the other side of the intermediate support layer, and the back bonding layer has a thickness not less than a height of the back reflective structure so that the back reflective structure is completely located in the back bonding layer. The present disclosure further provides a bifacial photovoltaic module with the bifacial reflective gap film.

## Description

### CROSS-REFERENCE TO RELATED APPLICATIONS

The present disclosure claims the priority of Chinese patent application No. 202420351969.2 titled "BIFACIAL REFLECTIVE GAP FILM AND BIFACIAL PHOTOVOLTAIC MODULE" filed with CNIPA on February 26, 2024, the entire contents of which are incorporated herein by reference.

### TECHNICAL FIELD

Embodiments of the present disclosure relate to, but are not limited to, the field of photovoltaic power generation, and specifically relate to a bifacial reflective gap film and a bifacial photovoltaic module with the bifacial reflective gap film.

### BACKGROUND

Solar photovoltaic power generation is a technology of directly converting light energy into electric energy by utilizing the photovoltaic effect of a semiconductor interface. With the increasing requirements of sustainable development of human economy and society on energy and environmental protection, this power generation method has gained more and more attention of people.

Current photovoltaic power generation modules are mainly divided into single-sided photovoltaic power generation modules and bifacial photovoltaic power generation modules. For a bifacial photovoltaic power generation module, the module generally includes a front plate (photovoltaic glass), a front transparent encapsulation adhesive film, photovoltaic cells, a back transparent encapsulation adhesive film, and a back plate (transparent back plate or glass). At present, it is still impossible to manufacture oversized photovoltaic cells. Therefore, a plurality of photovoltaic cells are generally arranged side by side in a photovoltaic power generation module. However, there may be gaps between the plurality of photovoltaic cells arranged side by side, influencing the power generation efficiency.

How to further improve the sunlight utilization rate by the photovoltaic cells and the output power of the photovoltaic module remains a problem to be solved and continuously explored by technicians.

### SUMMARY

An object of the present disclosure is to provide a bifacial reflective gap film applied to a bifacial photovoltaic module and aligned to a gap between two adjacent bifacial photovoltaic cells of the bifacial photovoltaic module. The bifacial reflective gap film includes: a back bonding layer, an intermediate support layer, a front reflective structure, and a back reflective structure, wherein the front reflective structure is disposed on one side of the intermediate support layer and includes a plurality of inverted V-shaped toothed members arranged side by side, and the front reflective structure is coated with a front reflective layer, the back reflective structure is disposed on the other side of the intermediate support layer, and the back bonding layer has a thickness not less than a height of the back reflective structure so that the back reflective structure is located in the back bonding layer.

Another object of the present disclosure is to provide a bifacial photovoltaic module, including: a photovoltaic glass front plate, a front transparent encapsulation adhesive film, a back transparent encapsulation adhesive film, a transparent or glass back plate, a bifacial reflective gap film, and a plurality of bifacial photovoltaic cells, wherein the bifacial reflective gap film is the bifacial reflective gap film according to any embodiment of the present disclosure.

### BRIEF DESCRIPTION OF DRAWINGS

FIG. 1 is a schematic diagram of a photovoltaic module according to an embodiment of the present disclosure.
FIG. 2 is a schematic diagram of a reflective gap film according to an embodiment of the present disclosure.
FIG. 3 is a schematic diagram of a bifacial photovoltaic module according to an embodiment of the present disclosure.
FIG. 4 is a schematic diagram of a bifacial reflective gap film according to an embodiment of the present disclosure.
FIG. 5 is a schematic diagram of a bifacial reflective gap film according to an embodiment of the present disclosure.
FIG. 6 is a schematic diagram of a bifacial reflective gap film according to an embodiment of the present disclosure.
FIG. 7 is a schematic diagram of a bifacial reflective gap film according to an embodiment of the present disclosure.
FIG. 8 is a schematic diagram of a bifacial reflective gap film according to an embodiment of the present disclosure.
FIG. 9 is a schematic diagram of a surface-insulated reflective gap film according to an embodiment of the present disclosure.
FIG. 10 is a schematic diagram of a surface-insulated bifacial reflective gap film according to an embodiment of the present disclosure.
FIG. 11 is a schematic diagram of a surface-insulated bifacial reflective gap film according to an embodiment of the present disclosure.
FIG. 12 is a schematic diagram of a surface-insulated bifacial reflective gap film according to an embodiment of the present disclosure.
FIG. 13 is a schematic diagram of a surface-insulated bifacial reflective gap film according to an embodiment of the present disclosure.
FIG. 14 is a schematic plan view of a photovoltaic module according to an embodiment of the present disclosure.
FIG. 15 is a schematic diagram of a bifacial reflective gap film according to an embodiment of the present disclosure.
FIG. 16 is a schematic diagram of a bifacial reflective gap film with a metal coating according to an embodiment of the present disclosure.

### DETAIL DESCRIPTION OF EMBODIMENTS

To improve understanding of the technical solution of the present disclosure for those skilled in the art, the bifacial reflective gap film and the bifacial photovoltaic module with the bifacial reflective gap film according to the present disclosure will be described in detail below in conjunction with the accompanying drawings.

Exemplary embodiments will be described more sufficiently below with reference to the accompanying drawings, but which may be embodied in different forms and should not be construed as limited to the embodiments set forth herein. Rather, these embodiments are provided so that the present disclosure will be thorough and complete, and will fully convey the scope of the present disclosure to those skilled in the art.

The embodiments of the present disclosure and features thereof may be combined with each other as long as they are not contradictory.

As used herein, the term "and/or" includes any and all combinations of one or more of the associated listed items.

The terminology used herein is for the purpose of describing specific embodiments only and is not intended to limit the present disclosure. As used herein, the singular forms "a", "an" and "the" are intended to include the plural forms as well, unless the context clearly indicates otherwise. It will be further understood that as used herein, the terms "comprise" and/or "consist of ..." specify the presence of the stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

To improve understanding of the technical solution of the present disclosure for those skilled in the art, exemplary embodiments will be explained in detail below. The following description refers to the accompanying drawings in which the same numbers in different drawings represent the same or similar elements unless otherwise indicated. The implementations described in the following exemplary embodiments do not represent all implementations consistent with the present disclosure. Rather, they are merely examples consistent with certain aspects disclosed in the embodiments, as detailed in the appended claims.

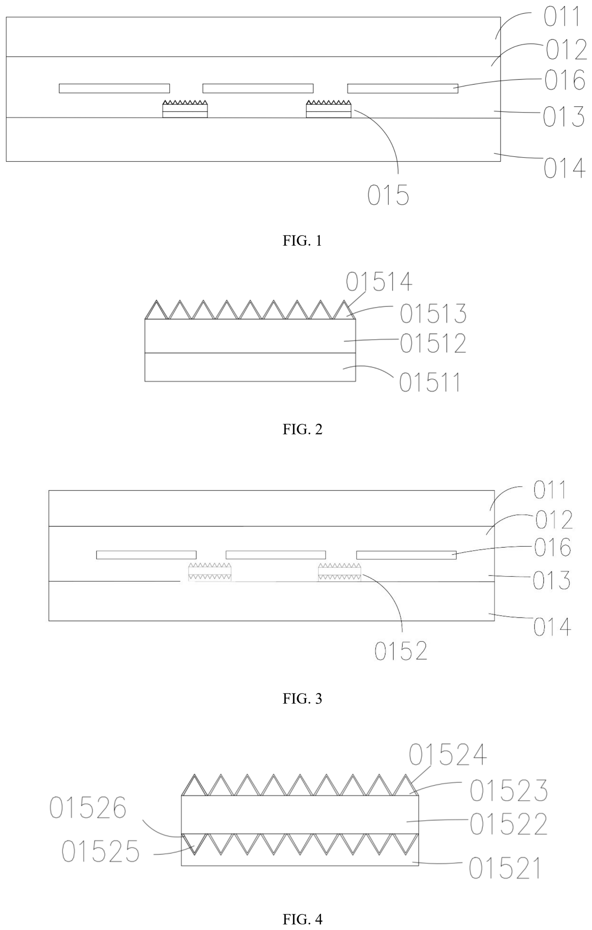

FIG. 1 is a schematic diagram of a photovoltaic module according to an embodiment of the present disclosure. As shown in FIG. 1, the photovoltaic module of the present disclosure includes: a photovoltaic glass front plate 011, a front transparent encapsulation adhesive film 012, a back transparent encapsulation adhesive film 013, a transparent or glass back plate 014, a reflective gap film 015, and a plurality of bifacial photovoltaic cells 016. The photovoltaic glass front plate 011 is disposed immediately above the front transparent encapsulation adhesive film 012 to protect the front transparent encapsulation adhesive film 012. The transparent or glass back plate 014 is disposed immediately below the back transparent encapsulation adhesive film 013 to protect the back transparent encapsulation adhesive film 013. The plurality of bifacial photovoltaic cells 016 are located side by side between the front transparent encapsulation adhesive film 012 and the back transparent encapsulation adhesive film 013. The reflective gap film 015 is located within the back transparent encapsulation adhesive film 013, placed above the transparent or glass back plate 014, and aligned to a gap between two adjacent bifacial photovoltaic cells 016. The photovoltaic glass front plate 011, the front transparent encapsulation adhesive film 012, the back transparent encapsulation adhesive film 013, the transparent or glass back plate 014, the reflective gap film 015 and the plurality of bifacial photovoltaic cells 016 are encapsulated into a photovoltaic module by welding photovoltaic cells, applying gap films, and lamination.

By providing the reflective gap film at the gap position between two adjacent bifacial photovoltaic cells 016, sunlight can be reflected back to the photovoltaic cells to be utilized again, thereby improving the output power and the power generation amount of the photovoltaic module. This is an effective way to boost the power of the photovoltaic module. The photovoltaic module for power generation is mainly suitable for scenes such as ground power stations.

FIG. 2 is a schematic diagram of a reflective gap film according to an embodiment of the present disclosure. As shown in FIG. 2, the reflective gap film 015 includes an intermediate support layer 01512, a back bonding layer 01511, a front reflective structure 01513, and a reflective layer 01514. The intermediate support layer 01512 is typically a relatively flat PET substrate support layer, while the back bonding layer 01511 employs an adhesive bonding layer to be bonded to the transparent or glass back plate 014. Such a reflective gap film can enable reuse of sunlight through a plurality of front reflective structures and reflective layers.

To improve the utilization rate of sunlight and the scattered light on the back side, the back bonding layer 01511 may be formed entirely or partially as a reflective layer, for example, a reflective layer containing titanium dioxide and the like, which serves as a back reflective structure. Alternatively, the back bonding layer 01511 may include a multi-layer structure, for example, a transparent sublayer-reflective sublayer-transparent sublayer structure. The transparent sublayers can meet the requirements of adhesion between different materials and flexibility and fluidity, while the reflective sublayer plays a role in reflection. The back bonding layer 01511 may be polymer resin of EVA or POE or composite resin of the two. Preferably, the back bonding layer 01511 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back reflective structure may be a material formed by doping at least one of titanium dioxide, zirconia, barium sulfate, or aluminum hydroxide into the polymer resin of EVA or POE or composite resin of the two.

To improve the utilization rate of sunlight and the scattered light on the back side, an embodiment of the present disclosure further provides a bifacial photovoltaic module and a bifacial reflective gap film.

FIG. 3 is a schematic diagram of a bifacial photovoltaic module according to an embodiment of the present disclosure. As shown in FIG. 3, the bifacial photovoltaic module of the present disclosure includes: a photovoltaic glass front plate 011, a front transparent encapsulation adhesive film 012, a back transparent encapsulation adhesive film 013, a transparent or glass back plate 014, a bifacial reflective gap film 0152, and a plurality of bifacial photovoltaic cells 016. The photovoltaic glass front plate 011 is disposed immediately above the front transparent encapsulation adhesive film 012 to protect the front transparent encapsulation adhesive film 012. The transparent or glass back plate 014 is disposed immediately below the back transparent encapsulation adhesive film 013 to protect the back transparent encapsulation adhesive film 013. The plurality of bifacial photovoltaic cells 016 are located side by side between the front transparent encapsulation adhesive film 012 and the back transparent encapsulation adhesive film 013. The bifacial reflective gap film 0152 is located within the back transparent encapsulation adhesive film 013, placed above the transparent or glass back plate 014, and aligned to a gap between two adjacent bifacial photovoltaic cells 016.

FIG. 4 is a schematic diagram of a bifacial reflective gap film according to an embodiment of the present disclosure. As shown in FIG. 4, the bifacial reflective gap film 0152 includes: a back bonding layer 01521, an intermediate support layer 01522, a front reflective structure 01523, and a back reflective structure 01525. The intermediate support layer 01522 is made of PET for example, and has a thickness of 10µm to 100µm. The front reflective structure 01523 is disposed on one side surface (the upper surface in FIG. 4) of the intermediate support layer 01522, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 01525 is disposed on the other side surface (the lower surface in FIG. 4) of the intermediate support layer 01522, and includes a plurality of V-shaped toothed members arranged side by side. Each of the V-shaped toothed members may be molded by UV curable glue and have an angle of 90° to 150°, preferably 100° to 140°, and more preferably 120°. The back bonding layer 01521 has a thickness not less than a height of the back reflective structure 01525 so that the back reflective structure 01525 is located or completely located in the back bonding layer 01521.

The front reflective structure 01523 is coated with a front reflective layer 01524. The front reflective layer 01524 may be an aluminum layer formed by vacuum aluminum plating, sputtering, and the like, and has a thickness of 1nm to 100nm, preferably 20nm to 100nm, and more preferably 30nm to 80nm. Similarly, the back reflective structure 01525 includes a back reflective layer 01526 coated on the back reflective structure. The back reflective layer 01526 may be an aluminum layer formed by vacuum aluminum plating, sputtering, and the like, and has a thickness of 1nm to 100nm, preferably 20nm to 100nm, and more preferably 30nm to 80nm.

The back bonding layer 01521 may be polymer resin of EVA, POE, PVB and the like, or composite resin of two or more of EVA, POE, PVB and the like, and has a thickness of 10µm to 100µm, preferably 30µm to 90µm. Preferably, the back bonding layer 01521 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer 01521 is configured to be bonded on the transparent or glass back plate 014 of the bifacial photovoltaic module.

A manufacturing process of the bifacial photovoltaic module and the bifacial reflective gap film provided in the embodiment may include: forming a UV curable glue molded structure with a reflective structure on a resin surface of a support layer by mold transfer printing, screen printing and the like; manufacturing an aluminum layer on a surface of the formed reflective structure by vacuum aluminum plating, sputtering and the like; integrating a bonding layer and the structure into a whole by cast lamination, film application, gluing and the like; applying the bonding layer of the bifacial reflective gap film to the back plate by heating; and then, performing welding, stacking and lamination of solar cells based on the structure of the photovoltaic module to manufacture the bifacial photovoltaic module for power generation.

To improve the utilization rate of sunlight and the scattered light on the back side, an embodiment of the present disclosure further provides a bifacial photovoltaic module and a bifacial reflective gap film.

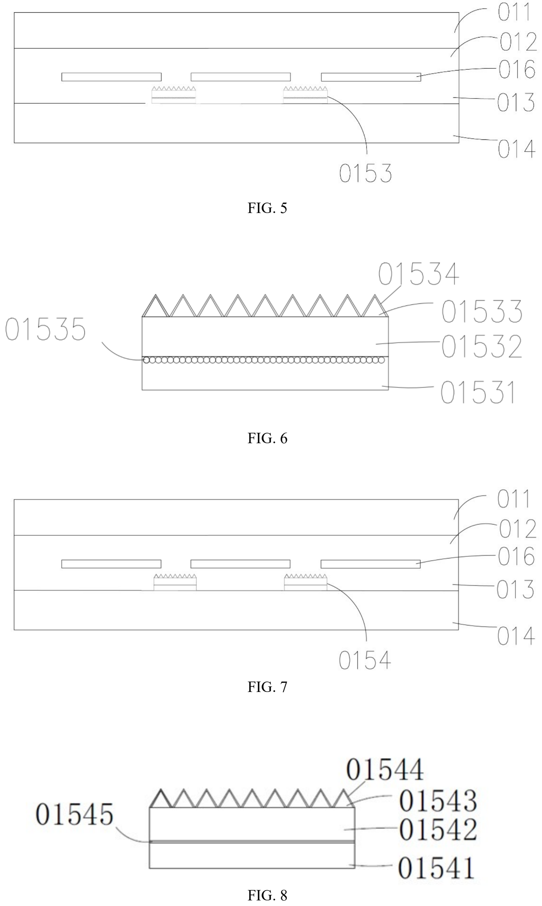

FIG. 5 is a schematic diagram of a bifacial photovoltaic module according to an embodiment of the present disclosure. As shown in FIG. 5, the bifacial photovoltaic module of the present disclosure includes: a photovoltaic glass front plate 011, a front transparent encapsulation adhesive film 012, a back transparent encapsulation adhesive film 013, a transparent or glass back plate 014, a bifacial reflective gap film 0153, and a plurality of bifacial photovoltaic cells 016. The photovoltaic glass front plate 011 is disposed immediately above the front transparent encapsulation adhesive film 012 to protect the front transparent encapsulation adhesive film 012. The transparent or glass back plate 014 is disposed immediately below the back transparent encapsulation adhesive film 013 to protect the back transparent encapsulation adhesive film 013. The plurality of bifacial photovoltaic cells 016 are located side by side between the front transparent encapsulation adhesive film 012 and the back transparent encapsulation adhesive film 013. The bifacial reflective gap film 0153 is located within the back transparent encapsulation adhesive film 013, placed above the transparent or glass back plate 014, and aligned to a gap between two adjacent bifacial photovoltaic cells 016.

FIG. 6 is a schematic diagram of a bifacial reflective gap film according to an embodiment of the present disclosure. As shown in FIG. 6, the bifacial reflective gap film 0153 includes: a back bonding layer 01531, an intermediate support layer 01532, a front reflective structure 01533, and a back reflective structure 01535. The intermediate support layer 01532 is made of PET for example, and has a thickness of 10µm to 100µm. The front reflective structure 01533 is disposed on one side surface (the upper surface in FIG. 6) of the intermediate support layer 01532, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 01535 is disposed on the other side surface (the lower surface in FIG. 6) of the intermediate support layer 01532. The back bonding layer 01531 has a thickness not less than a height of the back reflective structure 01535 so that the back reflective structure 01525 is located or completely located in the back bonding layer 01531.

The front reflective structure 01533 is coated with a front reflective layer 01534. The front reflective layer 01534 may be an aluminum layer formed by vacuum aluminum plating, sputtering, and the like, and has a thickness of 1nm to 100nm, preferably 20nm to 100nm, and more preferably 30nm to 80nm. As shown in FIG. 6, the back reflective structure 01535 includes spherical particles arranged compactly, where the spherical particles are made of at least one of titanium dioxide, zirconia, barium sulfate, aluminum hydroxide, and the like, and form a reflective coating.

The back bonding layer 01531 may be polymer resin of EVA, POE, PVB and the like, or composite resin of two or more of EVA, POE, PVB and the like, and has a thickness of 10µm to 100µm, preferably 30µm to 90µm. Preferably, the back bonding layer 01531 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

A manufacturing process of the bifacial photovoltaic module and the bifacial reflective gap film provided in the embodiment may include: forming a UV curable glue molded structure with a reflective structure on a resin front surface of a support layer by mold transfer printing, screen printing and the like; forming an aluminum layer on a surface of the formed reflective structure by vacuum aluminum plating, sputtering and the like; coating or spraying a reflective coating on the back surface, and drying; integrating a bonding layer and the back reflective coating into a whole by cast lamination, film application, gluing and the like; applying the bonding layer of the bifacial reflective gap film to the back plate by heating; and performing welding, stacking and lamination of solar cells based on the structure of the photovoltaic module to manufacture the bifacial photovoltaic module for power generation.

To improve the utilization rate of sunlight and the scattered light on the back side, an embodiment of the present disclosure further provides a bifacial photovoltaic module and a bifacial reflective gap film.

FIG. 7 is a schematic diagram of a bifacial photovoltaic module according to an embodiment of the present disclosure. As shown in FIG. 7, the bifacial photovoltaic module of the present disclosure includes: a photovoltaic glass front plate 011, a front transparent encapsulation adhesive film 012, a back transparent encapsulation adhesive film 013, a transparent or glass back plate 014, a bifacial reflective gap film 0154, and a plurality of bifacial photovoltaic cells 016. The photovoltaic glass front plate 011 is disposed immediately above the front transparent encapsulation adhesive film 012 to protect the front transparent encapsulation adhesive film 012. The transparent or glass back plate 014 is disposed immediately below the back transparent encapsulation adhesive film 013 to protect the back transparent encapsulation adhesive film 013. The plurality of bifacial photovoltaic cells 016 are located side by side between the front transparent encapsulation adhesive film 012 and the back transparent encapsulation adhesive film 013. The bifacial reflective gap film 0154 is located within the back transparent encapsulation adhesive film 013, placed above the transparent or glass back plate 014, and aligned to a gap between two adjacent bifacial photovoltaic cells 016.

FIG. 8 is a schematic diagram of a bifacial reflective gap film according to an embodiment of the present disclosure. As shown in FIG. 8, the bifacial reflective gap film 0154 includes: a back bonding layer 01541, an intermediate support layer 01542, a front reflective structure 01543, and a back reflective structure 01545. The intermediate support layer 01542 is made of PET for example, and has a thickness of 10µm to 100µm. The front reflective structure 01543 is disposed on one side surface (the upper surface in FIG. 8) of the intermediate support layer 01542, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 01545 is disposed on the other side surface (the lower surface in FIG. 8) of the intermediate support layer 01542. The back bonding layer 01541 has a thickness not less than a height of the back reflective structure 01545 so that the back reflective structure 01545 is located or completely located in the back bonding layer 01541.

The front reflective structure 01543 is coated with a front reflective layer 01544. The front reflective layer 01544 may be an aluminum layer formed by vacuum aluminum plating, sputtering, and the like, and has a thickness of 1nm to 100nm, preferably 20nm to 100nm, and more preferably 30nm to 80nm. The back reflective structure 01545 is an aluminum layer formed on the other side surface of the intermediate support layer 01542 through vacuum aluminum plating, sputtering, and the like, and has a thickness of 1nm to 100nm, preferably 20nm to 100nm, and more preferably 30nm to 80nm.

The back bonding layer 01541 may be polymer resin of EVA or POE and the like or composite resin of the two, and has a thickness of 10µm to 100µm, preferably 30µm to 90µm. Preferably, the back bonding layer 01541 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

A manufacturing process of the bifacial photovoltaic module and the bifacial reflective gap film provided in the embodiment may include: forming a UV curable glue molded structure with a reflective structure on a resin front surface of a support layer by mold transfer printing, screen printing and the like; forming an aluminum layer on a surface of the formed reflective structure by vacuum aluminum plating, sputtering and the like; forming an aluminum layer on a resin back surface of the support layer by vacuum aluminum plating, sputtering and the like; integrating a bonding layer and the back reflective coating into a whole by cast lamination, film application, gluing and the like; applying the bonding layer of the bifacial reflective gap film to the back plate by heating; and performing welding, stacking and lamination of solar cells based on the structure of the photovoltaic module to manufacture the bifacial photovoltaic module for power generation.

As described above, except for the bifacial reflective gap film in the embodiment shown in FIG. 2, the bifacial reflective gap films in the embodiments of FIGs. 4, 6 and 8 each have a back reflective structure. Table 1 below is a detailed comparison of the bifacial reflective gap film in the embodiment shown in FIG. 2 and the bifacial reflective gap films in the embodiments of FIGs. 4, 6 and 8.

**Table 1:**

| Item | Gap film in FIG. 2 | Gap film in FIG. 4 | Gap film in FIG. 6 | Gap film in FIG. 8 | Description of test conditions |
|---|---|---|---|---|---|
| Front reflectivity | 88.7% | 88.5% | 88.6% | 88.7% | Spectrophotometer 300nm to 1100nm |
| Back reflectivity | 52.4% | 73.5% | 70.2% | 72.7% | |
| UV120 KWH/m² yellowing value | △b=2.7 | △b=0.5 | △b=1.2 | △b=0.7 | Yellowing test, refer to GB\T 3979; GB\T 7921; testing on a back side of the sample |
| UV360 KWH/m² yellowing value | △b=5.7 | △b=1.3 | △b=1.9 | △b=1.3 | |
| UV+DH 75KWH/m² yellowing value | △b=3.7 | △b=0.6 | △b=1.3 | △b=0.9 | |
| UV+DH 225KWH/m² yellowing value | △b=8.7 | △b=3.5 | △b=4.2 | △b=3.6 | |
| DH1500 yellowing value | △b=1.7 | △b=0.3 | △b=0.5 | △b=0.6 | |
| DH1500 power attenuation | △Pm(F)=-2.54% | △Pm(F)=-2.38% | △Pm(F)=-2.24% | △Pm(F)=-2.27% | F represents a front power of the module, and B represents a back power of the module, Yellowing test is the same as above |
| | △Pm(B)=-3.54% | △Pm(B)=-3.01 % | △Pm(B)=-2.98% | △Pm(B)=-3.04% | |
| DH3000 yellowing value | △b=3.7 | △b=1.3 | △b=1.4 | △b=1.3 | |
| DH3000 power attenuation | △Pm(F)=-4.04% | △Pm(F)=-3.78% | △Pm(F)=-3.87% | △Pm(F)=-3.82% | |
| | △Pm(B)=-5.74% | △Pm(B)=-4.88% | △Pm(B)=-4.65% | △Pm(B)=-4.74% | |

As can be seen, by adopting the bifacial photovoltaic module and the bifacial reflective gap film provided in the embodiments of the present disclosure, the output power and power generation effect of the back surface of the bifacial cell photovoltaic module can be maximized while front power generation of the bifacial cell photovoltaic module is guaranteed, which can increase the output power of the back surface of the photovoltaic module by 0.2% to 3%. In addition, a back reflective structure is provided on the back surface of the bifacial reflective gap film, so that the intermediate support layer can be better protected, and the reliability of the bifacial reflective gap film is improved. The bifacial photovoltaic module and the bifacial reflective gap film provided in the embodiments of the present disclosure have good long-term reliability and process implementability, and have positive significance for improving the power generation efficiency of the photovoltaic module and reducing the levelized cost of energy (LCOE) of a photovoltaic power station.

As described above, the reflective layer of the reflective gap film is typically made of a UV-cured front reflective structure or an aluminum-plated material, which is susceptible to surface wear during rolling, unrolling, encapsulation and shipping of film tapes of reflective gap film. In addition, during lamination of the photovoltaic module, a tin-coated interconnection solder strip in the cell gap may generate tin dross, tin beads and uneven burrs, which may cause piercing of the encapsulation adhesive film. Once the adhesive film is damaged, an insulation distance between the interconnection solder strip and the reflective gap film will be reduced, which may cause local electric leakage, reduce the output power of the photovoltaic module and possibly cause reliability problems.

To cope with this problem, a thickness of the back transparent encapsulation adhesive film may be increased to increase the insulation distance. However, this method may increase the material cost of the encapsulation adhesive film, which is not favorable for the overall cost reduction and efficiency improvement of the photovoltaic module.

Based on the above problems, the present disclosure further proposes a surface-insulated bifacial reflective gap film which can effectively reduce surface wear of film tape during rolling, unrolling, encapsulation and shipping, thereby extending the service life. Due to the bifacial reflective material with the surface insulation characteristic, even if the thickness of the back transparent encapsulation adhesive film of the photovoltaic module is reduced, the insulation distance between the tin-coated interconnection solder strip in the cell gap and the gap film can be prevented from being shortened in the lamination process, so that the risk of local electric leakage is reduced, and the stability and reliability of the photovoltaic module are enhanced. In addition, while keeping the whole structure unchanged, such a surface-insulated bifacial reflective gap film will not influence the reflection efficiency of the film tape of the reflective gap film, so that the output power and the bifacial factor for the back side of the photovoltaic module are ensured while the reliability of the module is improved. Due to the insulation property of the surface material of the gap film, the film tape of the reflective gap film may be further extended to be applied to a periphery of the photovoltaic module, so that the overall performance of the module is further improved, and the cost is further reduced.

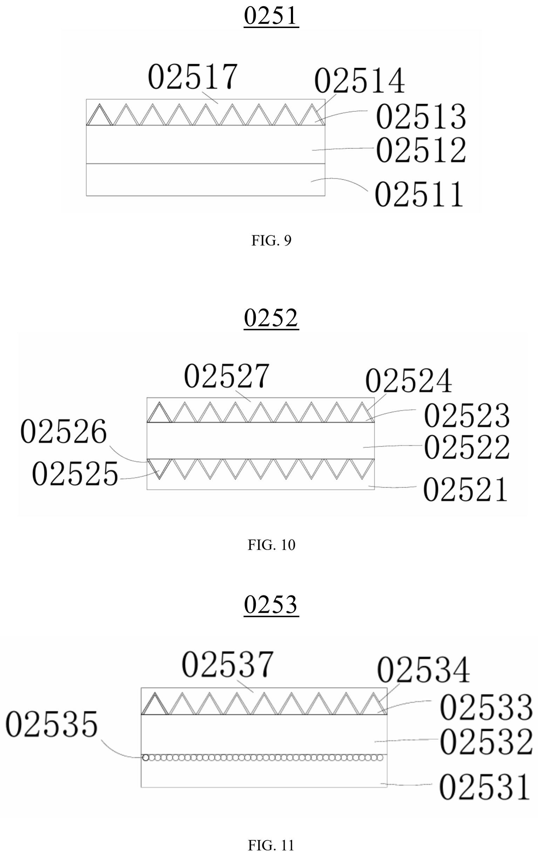

FIG. 9 is a schematic diagram of a surface-insulated reflective gap film according to an embodiment of the present disclosure. As shown in FIG. 9, the surface-insulated reflective gap film 0251 includes an intermediate support layer 02512, a back bonding layer 02511, a front reflective structure 02513, a reflective layer 02514, and a surface insulation layer 02517. The intermediate support layer 02512 is typically a relatively flat PET substrate support layer, while the back bonding layer 02511 employs an adhesive bonding layer to be bonded to the transparent or glass back plate 014.

The surface insulation layer 02517 is made of polymer resin such as ethylene vinyl acetate (EVA) copolymer, polyolefin elastomer (POE), polyvinyl butyral (PVB), or a composite of two or more of these resin materials. Due to low fluidity, these resin materials can ensure the formation of a uniform and flat surface during processing. To further enhance the performance of the surface insulation layer 02527, polymer particles with a lower melt index may be selected to help maintain film stability and consistency during film formation. In addition, after the film is formed, the mechanical property and chemical stability of the surface insulation layer may be further enhanced through electron irradiation crosslinking or thermal crosslinking treatment, to ensure the good insulating property of the surface insulation layer under various environmental conditions. The surface insulation layer can completely cover the surface of the reflective layer to form a relatively flat protective layer with good insulating property. This design not only improves the reliability and durability of the photovoltaic module, but also facilitates reduction of the production cost and more efficient energy conversion.

FIG. 10 is a schematic diagram of a surface-insulated bifacial reflective gap film according to an embodiment of the present disclosure. As shown in FIG. 10, the surface-insulated bifacial reflective gap film 0252 includes: a back bonding layer 02521, an intermediate support layer 02522, a front reflective structure 02523, and a back reflective structure 02525. The intermediate support layer 02522 is made of PET for example, and has a thickness of 10µm to 100µm. The front reflective structure 03523 is disposed on one side surface (the upper surface in FIG. 10) of the intermediate support layer 02522, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 02525 is disposed on the other side surface (the lower surface in FIG. 10) of the intermediate support layer 02522, and includes a plurality of V-shaped toothed members arranged side by side. Each of the V-shaped toothed members may be molded by UV curable glue and have an angle of 90° to 150°, preferably 100° to 140°, and more preferably 120°. The back bonding layer 02521 has a thickness not less than a height of the back reflective structure 02525 so that the back reflective structure 02525 is located or completely located in the back bonding layer 02521. The front reflective structure 02523 is coated with a front reflective layer 02524. The front reflective layer 02524 may be an aluminum layer formed by vacuum aluminum plating, sputtering, and the like, and has a thickness of 1nm to 100nm, preferably 20nm to 100nm, and more preferably 30nm to 80nm. Similarly, the back reflective structure 02525 includes a back reflective layer 02526 coated on the back reflective structure. The back reflective layer 02526 may be an aluminum layer formed by vacuum aluminum plating, sputtering, and the like, and has a thickness of 1nm to 100nm, preferably 20nm to 100nm, and more preferably 30nm to 80nm. The back bonding layer 02521 may be polymer resin of EVA or POE and the like or composite resin of the two, and has a thickness of 10µm to 100µm, preferably 30µm to 90µm. Preferably, the back bonding layer 02521 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

The front reflective layer 02524 of the front reflective structure 02523 is further provided with a surface insulation layer 02527 so that the surface insulation layer 02527 covers a surface of the front reflective layer 02524. The surface insulation layer 02527 has a relatively flat surface. The surface insulation layer 02527 is made of polymer resin such as ethylene vinyl acetate (EVA) copolymer, polyolefin elastomer (POE), polyvinyl butyral (PVB) and the like, or a composite of two or more of these resin materials. Due to low fluidity, these resin materials can ensure the formation of a uniform and flat surface during processing. To further enhance the performance of the surface insulation layer 02527, polymer particles with a lower melt index may be selected to help maintain film stability and consistency during film formation.

A manufacturing process of the bifacial photovoltaic module with the surface-insulated bifacial reflective gap film provided in the embodiment may include: forming a UV curable glue molded structure with a reflective structure on a resin surface of a support layer by mold transfer printing, screen printing and the like; manufacturing an aluminum layer on a surface of the formed reflective structure by vacuum aluminum plating, sputtering and the like; integrating a bonding layer and the structure into a whole by cast lamination, film application, gluing and the like; integrating a surface insulation layer and a reflective layer surface into a whole by cast lamination, film application, gluing and the like, and performing electron irradiation or thermal crosslinking treatment on the surface insulation layer to reduce the fluidity; applying the bonding layer of the bifacial reflective gap film to the back plate by heating; and then, during encapsulation, using a thinner back encapsulation adhesive film for the photovoltaic module to perform welding, stacking and lamination of solar cells based on the structure of the photovoltaic module to manufacture the bifacial photovoltaic module for power generation.

FIG. 11 is a schematic diagram of a surface-insulated bifacial reflective gap film according to an embodiment of the present disclosure. As shown in FIG. 11, the bifacial reflective gap film 0253 includes: a back bonding layer 02531, an intermediate support layer 02532, a front reflective structure 02533, and a back reflective structure 02535. The intermediate support layer 02532 is made of PET for example, and has a thickness of 10µm to 100µm. The front reflective structure 02533 is disposed on one side surface (the upper surface in FIG. 11) of the intermediate support layer 02532, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 02535 is disposed on the other side surface (the lower surface in FIG. 11) of the intermediate support layer 02532. The back bonding layer 02531 has a thickness not less than a height of the back reflective structure 02535 so that the back reflective structure 02525 is located or completely located in the back bonding layer 02531. The front reflective structure 02533 is coated with a front reflective layer 02534. The front reflective layer 02534 may be an aluminum layer formed by vacuum aluminum plating, sputtering, and the like, and has a thickness of 1nm to 100nm, preferably 20nm to 100nm, and more preferably 30nm to 80nm. As shown in FIG. 11, the back reflective structure 02535 includes spherical particles arranged compactly, where the spherical particles are made of at least one of titanium dioxide, zirconia, barium sulfate, aluminum hydroxide, and the like, and form a reflective coating. The back bonding layer 02531 may be polymer resin of EVA, POE and the like, or composite resin of the two, and has a thickness of 10µm to 100µm, preferably 30µm to 90µm. Preferably, the back bonding layer 02531 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

The front reflective layer 02534 of the front reflective structure 02533 is further provided with a surface insulation layer 02537 so that the surface insulation layer 02537 covers a surface of the front reflective layer 02534. The surface insulation layer 02537 has a relatively flat surface. The surface insulation layer 02537 is made of polymer resin such as ethylene vinyl acetate (EVA) copolymer, polyolefin elastomer (POE), polyvinyl butyral (PVB) and the like, or a composite of two or more of these resin materials. Due to low fluidity, these resin materials can ensure the formation of a uniform and flat surface during processing. To further enhance the performance of the surface insulation layer 02537, polymer particles with a lower melt index may be selected to help maintain film stability and consistency during film formation.

A manufacturing process of the bifacial photovoltaic module with the surface-insulated bifacial reflective gap film provided in the embodiment may include: forming a UV curable glue molded structure with a reflective structure on a resin front surface of a support layer by mold transfer printing, screen printing and the like; forming an aluminum layer on the surface of the formed reflection structure by adopting vacuum aluminum plating, sputtering and the like; coating or spraying a reflective coating on the back surface, and drying; integrating a bonding layer and the back reflective coating into a whole by cast lamination, film application, gluing and the like; integrating a surface insulation layer and a reflective layer surface into a whole by cast lamination, film application, gluing and the like, and performing electron irradiation or thermal crosslinking treatment on the surface insulation layer to reduce the fluidity; applying the bonding layer of the bifacial reflective gap film to the back plate by heating; and during encapsulation, using a thinner back encapsulation adhesive film for the photovoltaic module to perform welding, stacking and lamination of solar cells based on the structure of the photovoltaic module to manufacture the bifacial photovoltaic module for power generation.

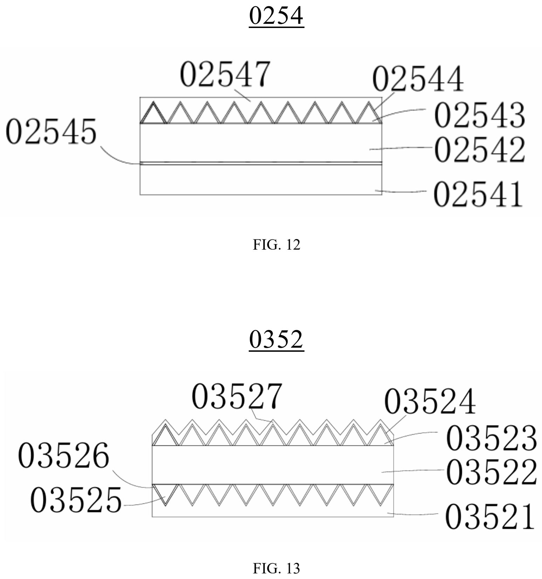

FIG. 12 is a schematic diagram of a surface-insulated bifacial reflective gap film according to an embodiment of the present disclosure. As shown in FIG. 12, the bifacial reflective gap film 0254 includes: a back bonding layer 02541, an intermediate support layer 02542, a front reflective structure 02543, and a back reflective structure 02545. The intermediate support layer 02542 is made of PET for example, and has a thickness of 10µm to 100µm. The front reflective structure 02543 is disposed on one side surface (the upper surface in FIG. 12) of the intermediate support layer 02542, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 02545 is disposed on the other side surface (the lower surface in FIG. 12) of the intermediate support layer 02542. The back bonding layer 02541 has a thickness not less than a height of the back reflective structure 02545 so that the back reflective structure 02545 is located or completely located in the back bonding layer 02541. The front reflective structure 02543 is coated with a front reflective layer 02544. The front reflective layer 02544 may be an aluminum layer formed by vacuum aluminum plating, sputtering, and the like, and has a thickness of 1nm to 100nm, preferably 20nm to 100nm, and more preferably 30nm to 80nm. The back reflective structure 02545 is an aluminum layer formed on the other side surface of the intermediate support layer 02542 through vacuum aluminum plating, sputtering, and the like, and has a thickness of 1nm to 100nm, preferably 20nm to 100nm, and more preferably 30nm to 80nm. The back bonding layer 02541 may be polymer resin of EVA, POE and the like, or composite resin of the two, and has a thickness of 10µm to 100µm, preferably 30µm to 90µm. Preferably, the back bonding layer 02541 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

The front reflective layer 02544 of the front reflective structure 02543 is further provided with a surface insulation layer 02547 so that the surface insulation layer 02547 covers a surface of the front reflective layer 02544. The surface insulation layer 02547 has a relatively flat surface. The surface insulation layer 02547 is made of polymer resin such as ethylene vinyl acetate (EVA) copolymer, polyolefin elastomer (POE), polyvinyl butyral (PVB) and the like, or a composite of two or more of these resin materials. Due to low fluidity, these resin materials can ensure the formation of a uniform and flat surface during processing. To further enhance the performance of the surface insulation layer 02547, polymer particles with a lower melt index may be selected to help maintain film stability and consistency during film formation.

A manufacturing process of the bifacial photovoltaic module with the surface-insulated bifacial reflective gap film provided in the embodiment may include: forming a UV curable glue molded structure with a reflective structure on a resin front surface of a support layer by mold transfer printing, screen printing and the like; forming an aluminum layer on a surface of the formed front reflective structure by vacuum aluminum plating, sputtering and the like; forming an aluminum layer on a surface of the formed back reflective structure by vacuum aluminum plating, sputtering and the like; integrating a bonding layer and the back reflective coating into a whole by cast lamination, film application, gluing and the like; integrating a surface insulation layer and a reflective layer surface into a whole by cast lamination, film application, gluing and the like, and performing electron irradiation or thermal crosslinking treatment on the surface insulation layer to reduce the fluidity; applying the bonding layer of the bifacial reflective gap film to the back plate by heating; and during encapsulation, using a thinner back encapsulation adhesive film for the photovoltaic module to perform welding, stacking and lamination of solar cells based on the structure of the photovoltaic module to manufacture the bifacial photovoltaic module for power generation.

FIG. 13 is a schematic diagram of a surface-insulated bifacial reflective gap film according to an embodiment of the present disclosure. As shown in FIG. 13, the surface-insulated bifacial reflective gap film 0352 includes: a back bonding layer 03521, an intermediate support layer 03522, a front reflective structure 03523, and a back reflective structure 03525. The intermediate support layer 03522 is made of PET for example, and has a thickness of 10µm to 100µm. The front reflective structure 03523 is disposed on one side surface (the upper surface in FIG. 13) of the intermediate support layer 03522, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The back reflective structure 03525 is disposed on the other side surface (the lower surface in FIG. 13) of the intermediate support layer 03522, and includes a plurality of V-shaped toothed members arranged side by side. Each of the V-shaped toothed members may be molded by UV curable glue and have an angle of 90° to 150°, preferably 100° to 140°, and more preferably 120°. The back bonding layer 03521 has a thickness not less than a height of the back reflective structure 03525 so that the back reflective structure 03525 is located or completely located in the back bonding layer 03521. The front reflective structure 03523 is coated with a front reflective layer 03524. The front reflective layer 03524 may be an aluminum layer formed by vacuum aluminum plating, sputtering, and the like, and has a thickness of 1nm to 100nm, preferably 20nm to 100nm, and more preferably 30nm to 80nm. Similarly, the back reflective structure 03525 includes a back reflective layer 03526 coated on the back reflective structure. The back reflective layer 03526 may be an aluminum layer formed by vacuum aluminum plating, sputtering, and the like, and has a thickness of 1nm to 100nm, preferably 20nm to 100nm, and more preferably 30nm to 80nm. The back bonding layer 03521 may be polymer resin of EVA, POE and the like, or composite resin of the two, and has a thickness of 10µm to 100µm, preferably 30µm to 90µm. Preferably, the back bonding layer 03521 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer is configured to be bonded on the transparent or glass back plate 014 of the bifacial photovoltaic module.

The front reflective layer 03524 of the front reflective structure 03523 is further provided with a surface insulation layer 03527 so that the surface insulation layer 03527 covers a surface of the front reflective layer 03524. The surface insulation layer 02527 has an uneven surface. The relatively uneven surface insulation layer can enable a larger contact surface area with the back adhesive film of the photovoltaic module, and further improve the bonding effect and reliability of the gap film and the encapsulation adhesive film. The surface insulation layer 02527 is made of polymer resin such as ethylene vinyl acetate (EVA) copolymer, polyolefin elastomer (POE), polyvinyl butyral (PVB) and the like, or a composite of two or more of these resin materials. To further enhance the performance of the surface insulation layer 03527, polymer particles with a lower melt index may be selected to help maintain film stability and consistency during film formation.

A manufacturing process of the bifacial photovoltaic module with the surface-insulated bifacial reflective gap film provided in the embodiment may include: forming a UV curable glue molded structure with a reflective structure on a resin surface of a support layer by mold transfer printing, screen printing and the like; manufacturing an aluminum layer on a surface of the formed reflective structure by vacuum aluminum plating, sputtering and the like; integrating a bonding layer and the structure into a whole by cast lamination, film application, gluing and the like; integrating a surface insulation layer and a reflective layer surface into a whole by cast lamination, film application, gluing and the like, and performing electron irradiation or thermal crosslinking treatment on the surface insulation layer to reduce the fluidity; applying the bonding layer of the bifacial reflective gap film to the back plate by heating; and then, during encapsulation, using a thinner back encapsulation adhesive film for the photovoltaic module to perform welding, stacking and lamination of solar cells based on the structure of the photovoltaic module to manufacture the bifacial photovoltaic module for power generation.

According to the surface-insulated bifacial reflective gap film disclosed in the embodiments of the present disclosure, the bonding layer of the surface-insulated bifacial reflective gap film is precisely attached to the back plate of the photovoltaic module by heating. This gap film is not only placed between cells and between cell strings, but also extended to peripheral edges of the photovoltaic module. In this process, welding of the solar cell, lamination of the module and a final lamination process are performed according to the standard structural requirements of the photovoltaic module, so that the reliability of the module is enhanced while bifacial power generation is implemented. Therefore, the photovoltaic module according to the embodiments of the present disclosure can fully utilize the sunlight, keep long-term stable operation, and provide powerful support for efficient conversion and application of solar energy.

As described above, the bifacial reflective gap films in the embodiments of FIGs. 4, 6 and 8 each have a back reflective structure. Compared with the bifacial reflective gap films in the embodiments of FIGs. 4, 6, and 8, the bifacial reflective gap films in the embodiments of FIGs. 9 to 13 each further have an insulation surface. Table 2 below is a detailed comparison of the reflective gap films in the embodiments of FIGs. 2, 4, 10, and 13.

**Table 2:**

| Item | Gap film in FIG. 2 | Gap film in FIG. 4 | Gap film in FIG. 10 | | Gap film in FIG. 13 | Note |
|---|---|---|---|---|---|---|
| Position of film application | Between cells and between cell strings | Between cells and between cell strings | Between cells and between cell strings | Between cells, between cell strings, and around the module | Between cells and between cell strings | |
| With gram weight of the back adhesive film | 420g/m² | 420g/m² | 400g/m² | 400g/m² | 400g/m² | |
| Front reflectivity | 88.7% | 88.5% | 88.6% | 88.6% | 88.5% | Spectrophot ometer 300nm to 1100nm |
| Increase in | 0.30% | 0.30% | 0.30% | 0.45% | 0.30% | |
| module power | | | | | | |
| Relative overall cost | 0 | +0.2 cm/W | -1.5 cm/W | -2.0 cm/W | -1.5 cm/W | |
| UV+DH 75KWH/m² yellowing value | b(F)=0.7 | b(F)=0.7 | b(F)=0.8 | b(F)=0.8 | b(F)=0.8 | Yellowing test, refer to GB\T 3979; GB\T 7921; F represents a front yellowing value of the sample, and B represents a back yellowing value of the sample. |
| | b(B)=3.7 | b(B)=0.6 | b(B)=0.7 | b(B)=0.7 | b(B)=0.5 | |
| UV+DH 225KWH/m² yellowing value | b(F)=1.6 | b(F)=1.7 | b(F)=1.6 | b(F)=1.6 | b(F)=1.7 | |
| | b(B)=8.7 | b(B)=3.5 | b(B)=3.6 | b(B)=3.6 | b(B)=3.4 | |
| DH1500 yellowing value | b(F)=0.5 | b(F)=0.4 | b(F)=0.6 | b(F)=0.6 | b(F)=0.7 | |
| | b(B)=1.7 | b(B)=0.3 | b(B)=0.4 | b(B)=0.4 | b(B)=0.3 | |
| DH1500 power attenuation | Pm(F)=-2.54% | Pm(F)=-2.38% | Pm(F)=-2.3 4% | Pm(F)=-2.34 % | Pm(F)=-2.29% | F represents a front power of the module, and B represents a back power of the module, Yellowing test is the same as above |
| | Pm(B)=-3.54% | Pm(B)=-3.01% | Pm(B)=-2. 88% | Pm(B)=-2.88 % | Pm(B)=-3.14% | |
| DH3000 yellowing value | b(F)=1.9 | b(F)=1.8 | b(F)=1.9 | b(F)=1.9 | b(F)=2.1 | |
| | b(B)=3.7 | b(B)=1.3 | b(B)=1.4 | b(B)=1.4 | b(B)=1.3 | |
| DH3000 power attenuation | Pm(F)=-4.04% | Pm(F)=-3.78% | Pm(F)=-3.8 7% | Pm(F)=-3.87 % | Pm(F)=-3.72% | |
| | Pm(B)=-5.74% | Pm(B)=-4.88% | Pm(B)=-4. 65% | Pm(B)=-4.65 % | Pm(B)=-4.54% | |

As described above, the bifacial reflective gap film mainly includes a back bonding layer, an intermediate support layer, a front reflective structure, and a back reflective structure. To further improve the light reflecting effect, a front reflective layer is further coated on the front reflective structure to increase the reflectivity. In these structures, the back bonding layer and the intermediate support layer are typically made of a polymer resin material such as PET, but these materials are likely to suffer discoloration and structural changes under high-temperature, high-humidity and ultraviolet irradiation environments, resulting in deteriorated reliability.

In view of this problem, one effective solution is to dope certain amounts of anti-aging additives and UV absorbents into the back bonding layer, or add a UV-blocking metal coating between the intermediate support layer and the back bonding layer. The anti-aging additives and the UV absorbents or the metal coating can protect the PET material from being damaged by ultraviolet rays, so that the anti-aging capability of the material is ensured, while the performance reduction of the bifacial reflective gap film caused by attenuation of the back bonding layer and the intermediate support layer is prevented. However, if the metal coating is too flat, it may directly reflect light out of the module from the back side, which may result in a reduced back power of the module, and thus affect the bifacial power generation efficiency of the photovoltaic module. Therefore, the metal coating needs to be designed to ensure that the metal coating can both effectively shield ultraviolet light and minimize the impact on the back power. In the present disclosure, by precisely controlling the roughness and the reflection characteristics of the metal coating, it is possible to maximally utilize solar rays while protecting materials, thereby improving the overall performance and power generation efficiency of the photovoltaic module.

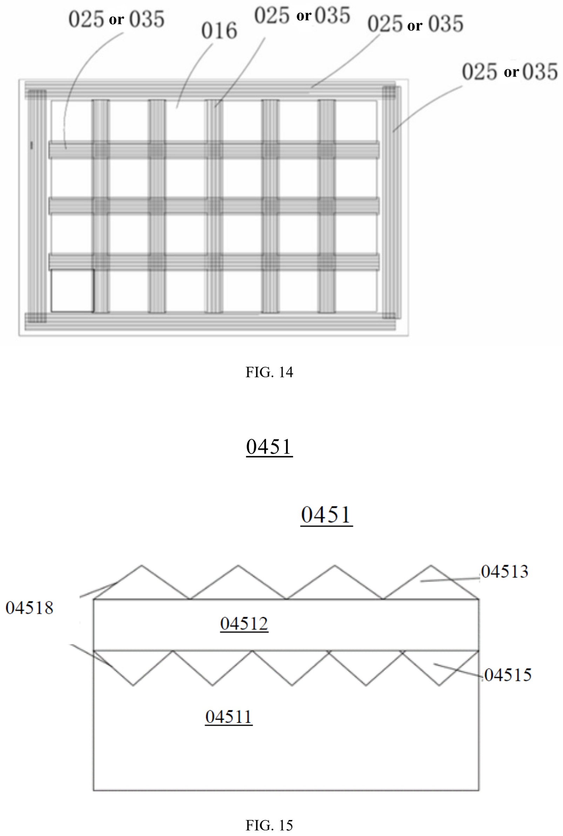

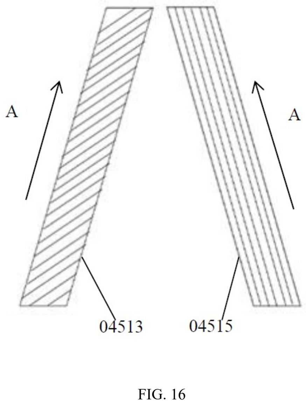

FIG. 15 is a schematic diagram of a bifacial reflective gap film according to an embodiment of the present disclosure. FIG. 16 is a schematic diagram of a bifacial reflective gap film with a metal coating according to an embodiment of the present disclosure. As shown in FIG. 15, the bifacial reflective gap film 0451 includes: a back bonding layer 04511, an intermediate support layer 04512, a front reflective structure 04513, and a back reflective structure 04515. The intermediate support layer 04512 is made of a transparent or translucent high polymer material such as PET, for example, and has a thickness of 10µm to 100µm, preferably 10nm to 60nm. The front reflective structure 04513 is disposed on one side surface (the upper surface in FIG. 15) of the intermediate support layer 04512, and includes a plurality of inverted V-shaped toothed members arranged side by side. Each of the inverted V-shaped toothed members may be molded by UV curable glue and have an angle of 90° to 150°, preferably 100° to 140°, and more preferably 120°. The front reflective structure 04513 has an overall thickness of 5µm to 20µm. As shown in FIG. 16, a surface of the front reflective structure 04513 is formed with texture structures parallel to each other, where the texture structures form an angle of 0° to 90°, preferably 10° to 80°, and more preferably 30° to 60°, with an extending direction A of a film tape of the bifacial reflective gap film (see the film tape of the reflective gap film 025 or 035 shown in FIG. 14). The back reflective structure 04515 is disposed on the other side surface (the lower surface in FIG. 15) of the intermediate support layer 04512, and includes a plurality of V-shaped toothed members arranged side by side. Each of the V-shaped toothed members may be molded by UV curable glue and have an angle of 90° to 150°, preferably 100° to 140°, and more preferably 120°. The back reflective structure 04515 has an overall thickness of 1µm to 50µm, preferably 5µm to 20µm. As shown in FIG. 16, a surface of the back reflective structure 04515 is formed with texture structures parallel to each other, where the texture structures form an angle of 0° to 90° with an extending direction A of a film tape of the bifacial reflective gap film (see the film tape of the reflective gap film 025 or 035 shown in FIG. 14). Preferably, the texture structures form an angle of 0° with an extending direction A of a film tape of the bifacial reflective gap film (see the film tape of the reflective gap film 025 or 035 shown in FIG. 14). That is, the texture structures of the back reflective structure 04515 is parallel to the extending direction A of the film tape of the bifacial reflective gap film. Considering that the utilization of sunlight on the back surface is low, the processing cost of the material is lower at an angle of 0°. The back bonding layer 04511 has a thickness not less than a height of the back reflective structure 04515 so that the back reflective structure 04515 is located or completely located in the back bonding layer 04511.

The front reflective structure 04513 is coated with a front reflective layer 04518. The front reflective layer 04518 may be an aluminum layer formed by vacuum aluminum plating, sputtering, and the like, and has a thickness of 1nm to 100nm, preferably 20nm to 100nm, and more preferably 30nm to 80nm. Similarly, the back reflective structure 04515 includes a back reflective layer 04518 coated on the back reflective structure. The back reflective layer 04518 may be an aluminum layer formed by vacuum aluminum plating, sputtering, and the like, and has a thickness of 1nm to 100nm, preferably 20nm to 100nm, and more preferably 30nm to 80nm.

The back bonding layer 04511 is made of polymer resin of EVA, POE or PVB, or composite resin of two or more of EVA, POE and PVB, and has a thickness of 10µm to 100µm, preferably 30µm to 90µm. Preferably, the back bonding layer 04511 is made of cross-linked EVA or POE with a crosslinking degree of 10% to 90%, preferably 10% to 30% or 50% to 80%, and more preferably 50% to 65%. The crosslinking degree may be adjusted as needed. For example, the crosslinking degree may depend on the specific formulation, lamination parameters, and test method. The back bonding layer 04511 is configured to be bonded on the transparent or glass back plate 014 of the bifacial photovoltaic module.

In the manufacturing processes of the front and back reflective structures, the UV glue is cured, typically by an embossing roller technology, to form the specific structure desired. However, when the embossed pattern has a larger angle (more than 10°) relative to the extending direction of the film tape, the quality of the UV glue structure may be deteriorated if a harder roller is used since it may be difficult to be separated from the cured UV glue, thereby affecting the expected light reflecting effect. In this case, a softer roller, for example a copper roller, is generally recommended to ensure smooth demolding. In contrast, when the pattern is at a smaller angle or substantially parallel to the extending direction of the film tape, smooth demolding can be achieved even with a harder roller, such as a nickel roller. The hard roller has less abrasion and longer service life in the process of continuously curing the UV glue, which contributes to significant reduction of the production cost.

Considering that the back side receives limited sunlight, the gain difference between angles of 0° and 10° to 80° is relatively small and may be neglected. Therefore, the back texture at an angle of 0° is preferable, which can not only reduce the damage to the roller during embossing, but also effectively extend the service life of the roller, thereby further reducing the manufacturing cost. This optimized scheme ensures the light reflecting effect while considering the production efficiency and cost control, providing an economic and efficient solution for manufacturing the photovoltaic module.

In this embodiment, front and back sides of the intermediate support layer of the bifacial reflective gap film are each covered with a metal coating which can effectively isolate ultraviolet rays and prevent aging and performance deterioration of the film material due to long-time exposure to ultraviolet rays. This property significantly improves the durability and service life of the gap film. By adding the back texture to the back reflective structure of the gap film, sunlight in a gap area of the back cells can be more efficiently utilized. This design can help to capture more scattered light and reflected light, so as to improve the bifacial power generation efficiency of the photovoltaic module, and increase the overall energy output.

It will be appreciated that embodiments of the present disclosure provide various types of bifacial reflective gap films, one or more of which may be selected for a photovoltaic module according to the specific design and performance requirements. Either used singly or in various combinations, these bifacial reflective gap films can provide the various advantages of the embodiments of the present disclosure, thereby providing great flexibility in the manufacture and application of the photovoltaic module, and enabling the photovoltaic module to better adapt to different installation environments and energy requirements.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present disclosure as set forth in the appended claims.

## Claims

1. A bifacial reflective gap film aligned to a gap between two adjacent bifacial photovoltaic cells of a bifacial photovoltaic module, wherein the bifacial reflective gap film comprises: a back bonding layer, an intermediate support layer, a front reflective structure, and a back reflective structure,
the front reflective structure is disposed on one side of the intermediate support layer and comprises a plurality of inverted V-shaped toothed members arranged side by side, and the front reflective structure is coated with a front reflective layer,
the back reflective structure is disposed on the other side of the intermediate support layer, and
the back bonding layer has a thickness not less than a height of the back reflective structure so that the back reflective structure is located in the back bonding layer.

2. The bifacial reflective gap film according to claim 1, wherein
each of the inverted V-shaped toothed members is molded by UV curable glue and has an angle of 90° to 150°,
the front reflective layer is an aluminum layer with a thickness of 20nm to 100nm,
the intermediate support layer is made of PET and has a thickness of 10µm to 100µm, and
the back bonding layer is polymer resin of EVA, POE or PVB, or composite resin of two or more of EVA, POE and PVB, and has a thickness of 10µm to 100µm.

3. The bifacial reflective gap film according to claim 1 or 2, wherein the back reflective structure comprises a plurality of V-shaped toothed members arranged side by side, each of which is molded by UV curable glue and has an angle of 90° to 150°, and
the back reflective structure comprises a back reflective layer coated on the back reflective structure, wherein the back reflective layer is an aluminum layer with a thickness of 20nm to 100nm.

4. The bifacial reflective gap film according to claim 1 or 2, wherein the back reflective structure comprises spherical particles arranged compactly to form a reflective coating.

5. The bifacial reflective gap film according to claim 1, wherein the back reflective structure is located in the back bonding layer to form a transparent sublayer-reflective sublayer-transparent sublayer structure, wherein the reflective sublayer serves as the back reflective structure.

6. The bifacial reflective gap film according to any one of claims 1 to 5, wherein the front reflective layer of the front reflective structure is further provided with a surface insulation layer covering a surface of the front reflective layer,
the surface insulation layer has a flat surface, and
the surface insulation layer is a thermosetting resin made of one or more polymer resins of EVA, POE and PVB.

7. The bifacial reflective gap film according to any one of claims 1 to 5, wherein the front reflective layer of the front reflective structure is further provided with a surface insulation layer covering a surface of the front reflective layer,
the surface insulation layer has an uneven surface, and
the surface insulation layer is a thermosetting resin made of one or more polymer resins of EVA, POE and PVB.

8. The bifacial reflective gap film according to claim 2, wherein the back reflective structure is a material formed by doping at least one of titanium dioxide, zirconia, barium sulfate, or aluminum hydroxide into the polymer resin of EVA or POE or composite resin of the two.

9. The bifacial reflective gap film according to claim 1 or 2, wherein
the back reflective structure is an aluminum layer formed on the other side of the intermediate support layer through vacuum aluminum plating or sputtering, and has a thickness of 20nm to 100nm.

10. The bifacial reflective gap film according to claim 1, wherein
each of the inverted V-shaped toothed members is molded by UV curable glue and has an angle of 90° to 150°,
the front reflective structure has an overall thickness of 1µm to 50µm, and a surface of the front reflective structure is formed with texture structures parallel to each other, wherein the texture structures form an angle of 0° to 90° with an extending direction of a film tape of the bifacial reflective gap film,
the front reflective layer is an aluminum layer with a thickness of 20nm to 100nm,
the intermediate support layer is made of PET and has a thickness of 10µm to 100µm, and
the back bonding layer is made of polymer resin of EVA, POE or PVB, or composite resin of two or more of EVA, POE and PVB, and has a thickness of 10µm to 100µm.

11. The bifacial reflective gap film according to claim 2 or 10, wherein the back bonding layer is made of cross-linked EVA or POE polymer resin or composite resin of the two, with a crosslinking degree of 10% to 90%.

12. The bifacial reflective gap film according to claim 10, wherein the back reflective structure comprises a plurality of V-shaped toothed members arranged side by side, each of which is molded by UV curable glue and has an angle of 90° to 150°, and
a surface of the back reflective structure is formed with texture structures parallel to each other, wherein the texture structures form an angle of 0° to 90° with an extending direction of a film tape of the bifacial reflective gap film.

13. A bifacial photovoltaic module, comprising: a photovoltaic glass front plate, a front transparent encapsulation adhesive film, a back transparent encapsulation adhesive film, a transparent or glass back plate, a bifacial reflective gap film, and a plurality of bifacial photovoltaic cells, wherein the bifacial reflective gap film is the bifacial reflective gap film according to any one of claims 1 to 12.

14. The bifacial photovoltaic module according to claim 13, wherein the photovoltaic glass front plate is disposed immediately above the front transparent encapsulation adhesive film to protect the front transparent encapsulation adhesive film, and the transparent or glass back plate is disposed immediately below the back transparent encapsulation adhesive film to protect the back transparent encapsulation adhesive film,
the plurality of bifacial photovoltaic cells are located side by side between the front transparent encapsulation adhesive film and the back transparent encapsulation adhesive film, and
the bifacial reflective gap film is located on a lower side of the back transparent encapsulation adhesive film and above the transparent or glass back plate.
